# EUROPEAN PATENT APPLICATION

(11) **EP 0 704 559 A1**
(43) Date of publication of application: **03.04.1996**
(21) Application number: 95401887.5
(22) Date of filing: 11.08.1995
(51) Int. Cl.: C30B 11/00, C30B 13/00, C30B 29/06

(54) **Method for the preparation of a substrate material for solar cells and a solar cell prepared by using the same**

(30) Priority: 05.09.1994 JP 210982/94
(71) Applicant: SHIN-ETSU CHEMICAL CO., LTD., Chiyoda-ku Tokyo (JP)
(72) Inventor: Sakaguchi, Susumu, Kawasaki-shi, Kanagawa-ken (JP); Arai, Shigeru, Tokyo (JP); Ozaki, Jun, Tokyo (JP); Hirasawa, Teruhiko, Kawasaki-shi, Kanagawa-ken (JP); Kamioka, Tadashi c/o Shin-Etsu Chemical Co., Ltd, Takatsu-ku, Kawasaki-shi, Kanagawa-ken (JP)
(74) Representative: Armengaud Ainé, Alain

(57) **Abstract**

The manufacturing process of a crystalline silicon semiconductor rod is simplified so as to decrease the cost and to supply inexpensive crystalline silicon substrates for solar cells so that the cost of the solar cells by using the same can be greatly decreased. The solar cell is characterized by the use of a silicon crystal substrate obtained by the immediate unidirectional solidification of a melt of metallic silicon produced by the reduction of silica rock in an electric furnace with carbon in a refractory columnar vessel into a polycrystalline silicon rod which is subjected to a treatment of the FZ method to be highly purified to give a silicon rod which is mechanically worked into silicon wafers to serve as the substrate of solar cells.

## Description

### BACKGROUND OF THE INVENTION

The present invention relates to a method for the preparation of a crystalline silicon substrate material for solar cells of low costs capable of working with a high photoelectric conversion efficiency and a solar cell prepared by using the substrate material.

In view of the limited abundance of fossil fuels and, more importantly than that, prevention of the global temperature increase due to the large-quantity consumption of energy of these fossil fuels by the mankind, solar cells are highlighted as a clean energy source and intensive studies are now underway for the full-scale practical use thereof.

Solar cells include those by the use of a single crystal of silicon, polycrystals of silicon or amorphous silicon and those by the use of the compound semiconductors of the III-V Groups, II-VI Groups and I-II-VI Groups of the Periodical Table but the full-scale practical use of each of them has not yet been developed excepting for some few applications under special circumstances.

The principal reason therefor is that the cost of power generation by means of solar cells is by far higher than the cost of the commercial electric power by the conventional power-generating methods at least in the developed countries. This is because a very high cost is required for the manufacture of solar cells by the conventional methods resulting in the expensiveness of the solar cells *per se*.

Accordingly, reduction of the manufacturing cost of solar cells is the key requirement for the prevalence and practical use thereof and technological development therefor is energetically undertaken in various countries although no promising results have yet been accomplished in the present status despite the so great efforts.

For example, the cost is relatively low when a thin film of amorphous silicon is used as the element of the solar cell but a problem therein is that the durability of such a solar cell is low due to the degradation of the characteristics of the solar cells and, in addition, the photoelectric conversion efficiency cannot be high enough inherently.

In the conventional method in which solar cells are manufactured from a silicon wafer prepared by slicing a silicon crystal rod grown by the CZ method (Czochralski method) or FZ method (floating zone melting method), on the other hand, solar cells of good durability without degradation of the characteristics and a high photoelectric conversion efficiency can be obtained but the cost to the preparation of the wafers from the starting material of silicon through the manufacturing process of single crystal rods and the material loss in the manufacture of wafers is so great that, as a result, the cost of solar cells is so remote from practical use in the present status. In this regard, the manufacturing cost of the silicon crystal rod can be decreased to some extent when the silicon crystal rod is polycrystalline but no alteration has been found in the so high costs for the manufacture of wafers due to the loss in slicing.

Accordingly, it would be a great approach toward prevalence and practical use of solar cells if a solar cell of low costs could be prepared from crystalline silicon of good durability and with high photoelectric conversion efficiency.

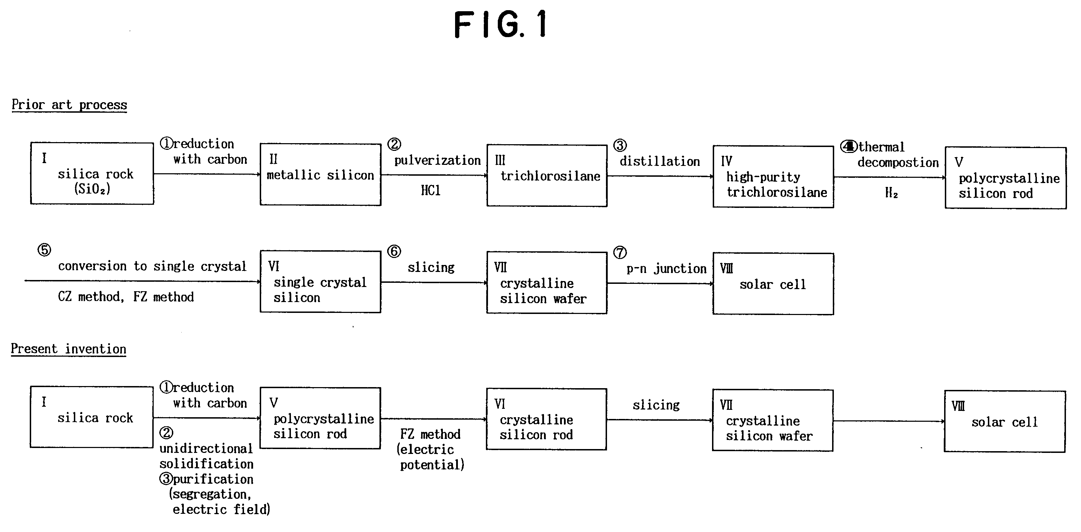

While a large number of steps must be undertaken until a crystalline silicon solar cell is finally prepared from silica rock as a starting material of silicon, the principal steps in general consist, as is shown in Figure 1, of seven steps including reduction of silica rock with carbon in an electric furnace, pulverization of metallic silicon and synthesis of a silane compound, distillation and purification of the silane compound, thermal decomposition of the silane compound to deposit silicon in the form of polycrystals, conversion of polycrystalline silicon into a single crystal rod by the CZ method or FZ method, slicing of the single crystal silicon rod into wafers and lapping of the wafers and preparation of a solar cell by the formation of a p-n junction on the single crystal silicon wafer. Accordingly, the key point for the cost reduction of crystalline silicon solar cells is in the possibility of simplification and cost reduction of these steps.

### SUMMARY OF THE INVENTION

The problem to be solved by the present invention consists in providing a crystalline silicon solar cell capable of working at a high photoelectric conversion efficiency and having good durability at low costs by fundamentally reconstructing the above mentioned steps from the above mentioned silica rock finally to the preparation of a crystalline silicon solar cell to attempt simplification of the steps without causing any quality degradation of the solar cell.

Thus, the scope of the present invention, which has been developed with an object to solve the above described problems in the conventional solar cells, consists in a method in which a melt of metallic silicon obtained by the reduction of silica rock with a carbonaceous material in an electric furnace is directly poured into a columnar vessel of a refractory material heated at the melting point of silicon or higher and then the melt of silicon in the columnar vessel is unidirectionally solidified by gradually cooling from the lower end of the vessel toward the upper end thereof to prepare a polycrystalline silicon rod.

The invention further provides a solar cell characterized in that the solar cell element is prepared from the above described polycrystalline silicon rod after a treatment for high purification and improvement in the crystallinity by the FZ method to be used as a silicon crystal substrate obtained by slicing the thus obtained crystalline silicon rod.

### BRIEF DESCRIPTION OF THE DRAWING

Figure 1 is an outline flow diagram starting from silica rock finally to obtain a crystalline silicon solar cell in the prior art and according to the present invention.

Figure 2a is a conceptional illustration in the conventional manufacture of metallic silicon.

Figure 2b is a conceptional illustration showing the unidirectional solidification of the melt of silicon according to the inventive method.

Figure 3 is a conceptional illustration for the application of a voltage in the FZ method.

Figure 4 is a cross sectional view of the structure of a solar cell in general used in the present invention.

### DETAILED DESCRIPTION OF THE PREFERRED EMBODIMENTS

With an object to attempt utmost simplification of the process steps, the inventors have completed the present invention on the base of such an idea as to directly prepare a polycrystalline silicon rod suitable as the starting material of the FZ method in a single step from the starting silica rock by omitting the steps of ② to ④ in the above mentioned Figure 1 starting from the silica rock I to the polycrystalline silicon rod V and then to remove the impurities which may cause degradation of the characteristics of the solar cells.

When the melt of metallic silicon obtained by the reduction of silica rock with a carbonaceous material in an electric furnace is directly poured into a columnar vessel of a refractory material heated at a temperature not lower than the melting point of silicon and then unidirectionally solidified by gradually cooling from the lower end of the vessel toward the upper end thereof to give a polycrystalline silicon rod along with segregation of impurities to the finally solidified end, high purification of the polycrystalline silicon rod can also be accomplished. Furthermore, the purity of the thus formed polycrystalline silicon rod can be still improved by the application of an electric field to the melt of the metallic silicon in the course of the unidirectional solidification in the columnar vessel.

Besides, also in the step of high purification by the FZ method, a possibility is given for the preparation of a crystallized silicon rod of high purity when an electric potential is applied between the starting polycrystalline silicon rod and the growing crystallized silicon rod so as to sweep down the impurities upwardly along the direction of solidification. As to boron and phosphorus which can hardly be removed by the unidirectional solidification because of their segregation coefficients each being close to 1, phosphorus is vaporized and boron can be removed as boron oxide B₂O₃ by conducting the FZ method under reduced pressure or in an oxidizing atmosphere or in a reduced-pressure oxidizing atmosphere.

In the following, still more detailed description is given of the present invention.

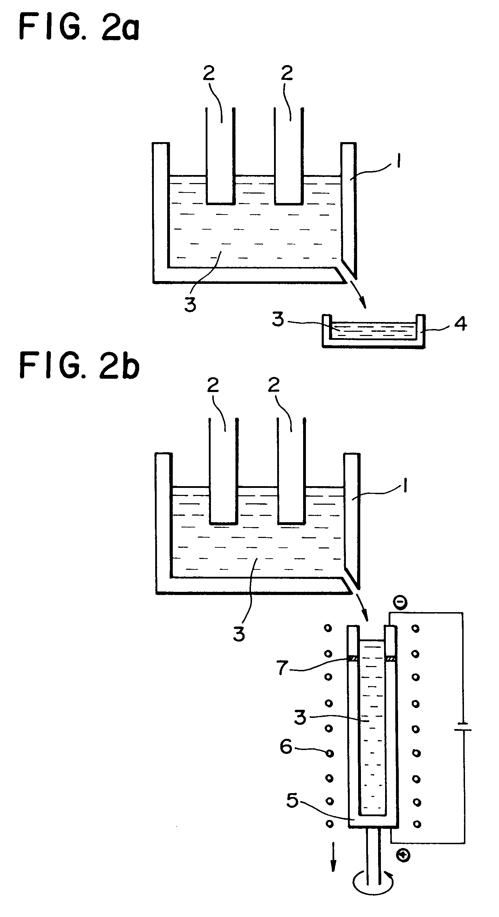

Usually, metallic silicon of industrial grade is manufactured, as is illustrated in Figure 2a, by mixing silica rock or silica sand with coke or coal and reducing the siliceous material by heating the blend in a large arc furnace 1 by supplying a large electric power to the electrodes 2. The metallic silicon formed in this case is obtained as a melt 3 on the bottom of the furnace 1. The melt 3 of silicon is periodically discharged out of the furnace 1 into a ladle 4 outside of the furnace 1 to be solidified in a casting mold by spontaneous cooling followed by pulverization into an appropriate particle size to be used as a starting material in the subsequent step (see the steps ① and ② of Figure 1).

The metallic silicon thus obtained in the conventional metallurgical process contains substantial amounts of impurities coming from the silica rock and the carbonaceous material as the starting materials and other members inside of the furnace. The contents of the impurities have different values depending on the manufacturers of the metallic silicon but the analytical values such as those in Table 1 are conventional as a typical case.

As is understood from the fact that these impurities are contained in the metallic silicon, almost no segregation of impurities is caused in the melt discharged into the ladle and solidified there due to the rapid solidification of the melt in the mold and the melt is converted into the form of an ingot of metallic silicon having the impurity concentrations approximately similar to the above given analytical values.

In contrast thereto, in the method of the present invention illustrated in Figure 2b, the melt 3 of metallic silicon is discharged out of the electric furnace 1 by pouring, not into a ladle 4 in Figure 2a, into a columnar vessel 5 heated at a temperature not lower than the melting point of silicon by using a suitable heating means 6. This vessel 5 is made from a refractory material such as, for example, graphite and, in order to prevent immediate solidification of the melt 3 discharged out of the furnace 1, directly or indirectly heated from the side surfaces by a conventional heating means 6 such as resistance heaters, lamp heaters, high frequency induction heaters and the like.

**Table 1**

| Impurity element | Concentration, ppm by weight | Segregation coefficient |
|---|---|---|
| Boron | 25 | 0.8 |
| Phosphorus | 50 | 0.35 |
| Aluminum | 1,000 | 3.0 × 10⁻ |
| Calcium | 850 | - |
| Nickel | 50 | 1.3 × 10⁻⁴ |
| Copper | 60 | 8.0 × 10⁻⁴ |
| Chromium | 20 | 1.1 × 10⁻⁵ |
| Manganese | 140 | 1.3 × 10⁻⁵ |
| Titanium | 90 | 2.0 × 10⁻⁶ |
| Magnesium | 50 | 3.2 × 10⁻⁶ |
| Vanadium | 200 | 4.0 × 10⁻⁶ |
| Iron | 6,300 | 6.4 × 10⁻⁶ |
| Zirconium | 30 | 1.6 × 10⁻⁸ |

The columnar vessel 5 and/or the heating means 6 are provided with a driving mechanism to be moved in the up and down direction and, after the melt 3 of silicon has been taken in the vessel 5, the vessel 5 containing the melt 3 of metallic silicon is gradually moved downwardly relative to the heating means 6 so as to come out of the heating zone from the lower end of the vessel 5 so that solidification of the melt 3 of metallic silicon in the vessel 5 starts at the lower end to be solidified as a whole into a columnar form as the solidification proceeds toward the upper end by being successively cooled unidirectionally. In this unidirectional solidification, different from the solidification of the whole volume of the melt 3 nearly at one time as in a ladle 4, the melt 3 is gradually solidified from the lower end to the upper end of the columnar vessel so that the impurity elements can be segregated in the upward direction in an approximately equilibrated state (see Figure 2b).

In this case, while the velocity of the unidirectional solidification can be controlled by modifying the downward moving velocity of the columnar vessel or the upward moving velocity of the heating means, the state of equilibration is lost when the solidification velocity is too large and the impurities are taken into the solid to decrease the effect of segregation along with a decrease in the crystallinity of the columnar polycrystalline silicon rod to be obtained and, in addition, denseness is decreased to readily cause crack formation or be broken not to be usable subsequently as the starting material of the FZ method. Accordingly, it is desirable that the velocity of the unidirectional solidification does not exceed 1000 mm/hour or, preferably, does not exceed 100 mm/hour. Further, the columnar vessel can be provided with a mechanism for revolution around the vertical axis so that the unidirectional solidification can be performed under rotation to enable more uniform solidification to give a polycrystalline silicon rod having higher denseness with uniform crystalline grains.

And, the method for effecting unidirectional solidification from the lower end to the upper end is not limited to the above mentioned method of the up and down movement of the columnar vessel and/or the heating means but various alternatives are possible including a method in which the heating means is divided into several parts arranged along the up and down direction and the power supply is gradually decreased starting from the lowermost part of the heating means to the uppermost part thereof.

The unidirectional solidification is performed starting at the lower end toward the upper end of the columnar vessel 5 because, while the same effect can be obtained even when it is from the upper end toward the lower end if it were only for the purpose of segregation removal of the impurities, silicon causes volume expansion in solidification from melt to solid so that, when solidification is effected from the upper end toward the lower end which is closed by the bottom of the vessel 5, the vessel is destroyed by the expansion of silicon. Accordingly, the unidirectional solidification is effected desirably toward the open end, i.e. the upper end.

Further, an electric potential can be applied between the upper and lower ends of the columnar vessel 5 in the step of this unidirectional solidification, the upper end being negative relative to the lower end, so that the impurities are more efficiently swept down upwardly by the electric field to promote the effect of segregation by the unidirectional solidification. It is of course in this case that the upper and lower ends of the vessel must be electrically insulated by inserting an insulating member 7 as is illustrated in Figure 2b.

The polycrystalline silicon rod obtained in this way is freed by cutting from the upper end portion where the impurities are accumulated by segregation and the lower end surface and side surface layers contaminated by contacting with the inner surface of the columnar vessel by grinding or polishing or etching or a combination thereof so as to give a polycrystalline silicon rod having a very high purity as compared with conventional metallic silicon of the industrial grade.

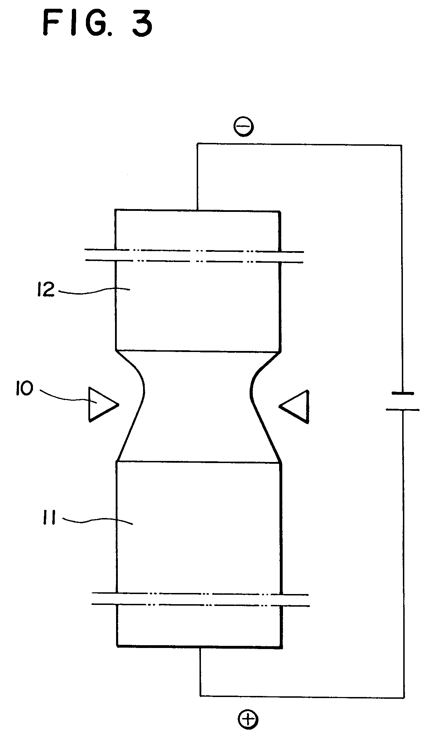

Once a polycrystalline silicon rod is obtained in this way, a solar cell is prepared subsequently according to the same process as in the prior art (Figure 1, ⑤ to ⑦) but a solar cell having a high efficiency can not always be obtained from the polycrystalline silicon rod as such so that it is desirably imparted with a higher purity by the FZ method as is illustrated in Figure 3. As to boron and phosphorus, in particular, a great decrease is hardly accomplished by the unidirectional solidification alone because the segregation coefficients thereof are each close to 1.

Accordingly, an electric potential can be applied between the portion 11 and the portion 12 below and above, respectively, the zone-melted portion surrounded by a high frequency induction coil 10 in conducting the FZ method to impart the polycrystalline silicon rod with a high purity so that removal of the impurities remaining in the polycrystalline rod can be promoted and, further, when the atmosphere is under reduced pressure or oxidizing or oxidizing under reduced pressure, the elements such as, for example, phosphorus capable of being readily vaporized at a high temperature under reduced pressure are vaporized or the elements such as, for example, boron capable of readily forming an oxide are precipitated on the surface layer or vaporized as an oxide so that the concentrations in silicon can be efficiently decreased. In this case, the degree of pressure reduction is desirably necessarily 500 Torr or lower in order to promote vaporization of mainly phosphorus and preferably 50 Torr or lower. And, a gaseous mixture of an inert gas such as argon, nitrogen and the like with water vapor or oxygen can be used as the oxidizing atmosphere and it is effective that the volume fraction thereof does not exceed 20% or, preferably, is in the range from 1 to 10%.

In the following, an example of the present invention is described but the present invention is never limited thereto.

### Example.

A graphite-made columnar vessel having an inner diameter of 50 mm and a depth of 40 cm was prepared for use in the unidirectional solidification of a melt of silicon. While this graphite-made vessel was kept at 1450 °C by the method of high frequency heating, a melt of metallic silicon was poured thereinto. In the next place, this vessel containing the melt of metallic silicon was moved downwardly at a velocity of 10 mm/hour so as to effect gradual unidirectional solidification of the melt starting at the lower end of the vessel to proceed upwardly to give a columnar polycrystalline silicon rod.

A 10 cm long upper end portion of the thus formed polycrystalline silicon rod was removed by cutting and the surface layer of the bottom end and the side surface layer were removed by about 5 mm thickness by grinding. In the next place, the surface layer of the same was removed by etching with a mixed solution of hydrofluoric and nitric acids followed by thorough rinse with pure water.

This polycrystalline silicon rod was subjected to the analysis of the impurity contents in the upper and lower end portions to find that decrease of the impurity elements was accomplished as is shown in Table 2 below.

**Table 2**

| Impurity element | Content in starting material | Lower end portion | Upper end portion |
|---|---|---|---|
| Boron | 15 ppm | 10 ppm | 15 ppm |
| Phosphorus | 30 ppm | 10 ppm | 20 ppm |
| Aluminum | 950 ppm | 60 ppm | 150 ppm |
| Calcium | 750 ppm | <1 ppm | <1 ppm |
| Copper | 10 ppm | <1 ppm | <1 ppm |
| Manganese | 120 ppm | <1 ppm | <1 ppm |
| Titanium | 80 ppm | <1 ppm | <1 ppm |
| Iron | 3,000 ppm | <1 ppm | 5 ppm |

Further, another polycrystalline silicon rod was prepared in the same manner as above excepting application of an electric voltage of 10 volts between the upper and lower ends of the graphite-made columnar vessel in the unidirectional solidification of the silicon melt therein and the silicon rod was subjected to the analysis of the impurity contents to find a still enhanced decreasing effect of the impurity contents as is shown in Table 3 below.

**Table 3**

| Impurity element | Lower end portion | Upper end portion |
|---|---|---|
| Boron | 10 ppm | 15 ppm |
| Phosphorus | 10 ppm | 15 ppm |
| Aluminum | 40 ppm | 120 ppm |
| Iron | <1 ppm | 1 ppm |

The thus formed polycrystalline silicon rod by the application of voltage between the upper and lower ends of the columnar vessel was further purified by the FZ method. The atmosphere was a gaseous mixture of oxygen and argon in a proportion of 1:99 by volume under a pressure of 10 Torr and the velocity of crystal growing was 30 mm/hour. The surface layer of the thus formed crystalline silicon rod was removed by etching with a mixed solution of hydrofluoric and nitric acids followed by thorough rinse with pure water.

As a result of the analysis of the purity of this crystalline silicon rod for the upper and lower end portions, it was found that a decrease of impurity elements was accomplished by undertaking the FZ procedure as is shown in Table 4 given below.

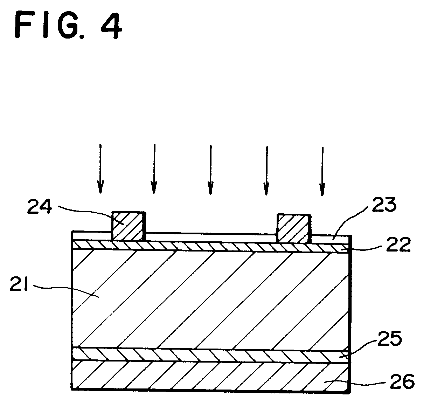

The thus obtained crystalline silicon rod was sliced into wafers and a solar cell was prepared therefrom according to a conventional method. The structure of the solar cell was, though not particularly limitative, that illustrated in Figure 4 as a typical one. Assuming that the silicon substrate 21 is of the p-type, it is provided on the upper surface with a n+ layer 22 covered with a reflection-preventing transparent coating layer 23 and on the lower surface with a p+ layer 25 and they are provided with an upper electrode 24 and lower electrode 26, respectively. When the sunlight (shown by the downward arrows) falls on the upper surface, an electromotive force is generated between the electrodes 24, 26.

**Table 4**

| Impurity element | Lower end portion | Upper end portion |
|---|---|---|
| Boron | 1 ppm | 5 ppm |
| Phosphorus | <1 ppm | 5 ppm |
| Aluminum | <1 ppm | 10 ppm |
| Calcium | <1 ppm | <1 ppm |
| Copper | <1 ppm | <1 ppm |
| Manganese | <1 ppm | <1 ppm |
| Titanium | <1 ppm | <1 ppm |
| Iron | <1 ppm | <1 ppm |

The photoelectric conversion efficiency of this solar cell was measured under the conditions of AM 1.5, 100 mW/cm at 28 °C to find a satisfactory result of 12.0% giving a conclusion that the silicon wafer prepared according to the inventive method was absolutely without problems in continued use.

As is understood from the above given description, according to the present invention, the manufacturing process of the crystalline silicon semiconductor as a substrate material for solar cells can be greatly simplified as compared with the conventional process so that inexpensive and high purity crystalline silicon can be provided. Consequently, the cost of the solar cells by using the same can be decreased, in addition, with excellent photoelectric conversion efficiency and durability so that great contribution can be accomplished to the prevalence and practical use of solar cells.

## Claims

1. A method for the preparation of a silicon rod which comprises the steps of:
forming a rod by subjecting a melt of silicon to unidirectional solidification; and
then subjecting the rod to a treatment of the FZ method.

2. The method for the preparation of a silicon rod as claimed in claim 1 in which the melt of silicon is subjected to unidirectional solidification in a columnar vessel of a refractory material into which the melt is poured.

3. The method for the preparation of a silicon rod as claimed in claim 2 in which said vessel is heated at a temperature not lower than the melting point of silicon prior to the unidirectional solidification.

4. The method for the preparation of a silicon rod as claimed in claim 3 in which the melt of silicon is obtained by the reduction of silica and said unidirectional solidification is conducted immediately after the reduction.

5. The method for the preparation of a silicon rod as claimed in claim 4 in which said unidirectional solidification is conducted by gradually cooling from the lower end of the vessel toward the upper end.

6. The method for the preparation of a silicon rod as claimed in claim 5 in which, after the unidirectional solidification, the finally solidified end portion of and the surface layer of the rod of solidified silicon are removed.

7. The method for the preparation of a silicon rod as claimed in claim 1 in which, in the course of the unidirectional solidification, an electric potential is applied to the melt contained in the columnar vessel.

8. The method for the preparation of a silicon rod as claimed in claim 1 in which, in the course of the treatment of the silicon rod by the FZ method, an electric potential is applied to the silicon rod.

9. The method for the preparation of a silicon rod as claimed in claim 1 in which the treatment of the silicon rod by the FZ method is performed under a reduced pressure or in an oxidizing atmosphere.

10. A silicon solar cell of which the silicon substrate is obtained from a wafer of the silicon rod prepared by subjecting a melt of silicon to unidirectional solidification to be converted into a rod of silicon followed by a treatment of the FZ method.
